# EUROPEAN PATENT APPLICATION

(11) **EP 4 354 489 A1**
(43) Date of publication of application: **17.04.2024**
(21) Application number: 22819841.2
(22) Date of filing: 03.03.2022
(51) Int. Cl.: H01L 21/20

(54) **NITRIDE SEMICONDUCTOR SUBSTRATE AND METHOD FOR PRODUCING SAME**

(30) Priority: 08.06.2021 JP 2021096071
(71) Applicant: Shin-Etsu Handotai Co., Ltd., Tokyo 100-0004 (JP)
(72) Inventor: KUBONO, Ippei, Annaka-shi, Gunma 379-0196 (JP); HAGIMOTO, Kazunori, Annaka-shi, Gunma 379-0196 (JP); SHINOMIYA, Masaru, Annaka-shi, Gunma 379-0196 (JP)
(74) Representative: Sonnenhauser, Thomas Martin
(86) International application number: PCT/JP2022/009006
(87) International publication number: WO 2022/259651

(57) **Abstract**

The present invention provides a nitride semiconductor substrate including a substrate for film formation including a composite substrate having a plurality of layers bonded together and a single-crystal silicon layer formed on the composite substrate and a nitride semiconductor thin film formed on the substrate for film formation. The nitride semiconductor thin film includes a GaN layer, and the GaN layer is doped with at least 1×10¹⁹ atoms/cm³ or more and less than 5×10²⁰ atoms/cm³ of carbon and/or 5×10¹⁸ atoms/cm³ or more and less than 5×10²⁰ atoms/cm³ of iron. Thereby, the nitride semiconductor substrate with an improved high-frequency characteristic and a method of producing this substrate can be provided.

## Description

### TECHNICAL FIELD

The present invention relates to a nitride semiconductor substrate and a method of producing the substrate.

### BACKGROUND ART

Metal-organic chemical vapor disposition (MOCVD), which is one of the methods of producing a semiconductor thin film, is widely used because of superiority in enlargement of diameter and mass productivity and ability to form a homogeneous thin-film crystal. In addition, a nitride semiconductor represented by GaN is expected as a semiconductor material for the next generation, exceeding the limitation of Si as the material.

GaN has characteristics of high saturated electron velocity and thus can produce a device capable of high-frequency operation and is operable at a higher output due to a large dielectric breakdown electric field. Moreover, weight reduction, miniaturization, and lower electric power consumption can be expected.

In recent years, the demand for an accelerated communication speed represented by 5G and an accompanying higher output has attracted attention toward a GaN high electron mobility transistor (HEMT) operable at high frequency and high output.

A Si substrate is the most inexpensive substrate used for a GaN epitaxial wafer to produce a GaN device and is also advantageous for the enlargement of a diameter. In addition, the SiC substrate is also used due to its high thermal conductivity and therefore good heat dissipation. However, these substrates have different coefficients of thermal expansion with GaN. Thus, stress applied due to a cooling process after an epitaxial film-forming is likely to generate a crack. Moreover, forming a thick film from GaN is impossible, and even if a complicated stress-relaxation layer is film-formed within an epitaxial layer, a limit of the crack-free thickness is about 5 um at most.

A GaN substrate has the same (or very close to) coefficients of thermal expansion with a GaN epitaxialgrown layer. Thus, such a problem described above is unlikely to come up. However, a free-standing GaN substrate is not only difficult to produce but also inappropriate for mass production due to its extremely high cost and inability to produce a substrate with a large diameter.

As a result, a large-diameter substrate (hereafter, a substrate for GaN film formation) for GaN epitaxial growth with a large diameter and a coefficient of thermal expansion close to GaN has been developed.

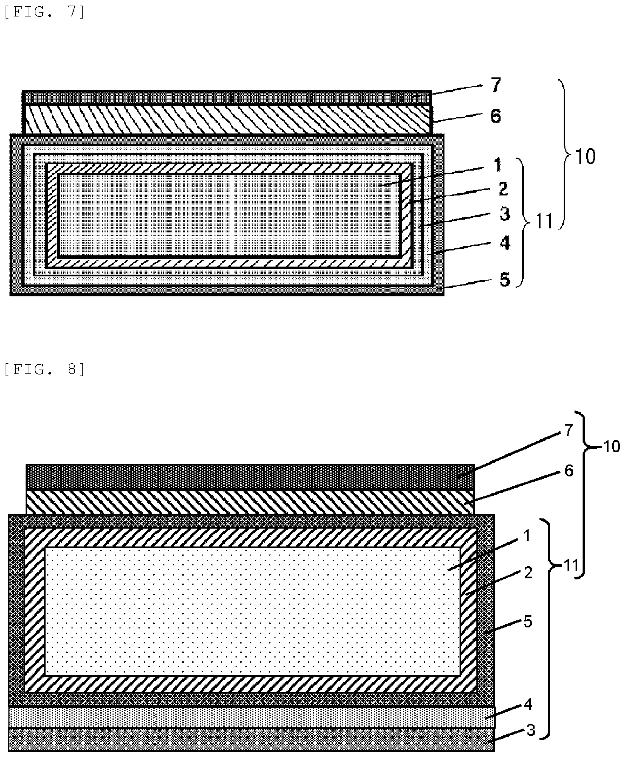

FIG. 7 shows an example of the substrate for GaN film formation. A substrate 10 for GaN film formation in this example, as shown in FIG. 7, includes: a composite substrate 11 including a polycrystalline ceramic core 1, a first adhesive layer 2 bonded entirely to the polycrystalline ceramic core 1, a conductive layer 3 bonded entirely to the first adhesive layer 2, a second adhesive layer 4 bonded entirely to the conductive layer 3, and a barrier layer 5 (a silicon nitride layer, for example) bonded entirely to the second adhesive layer 4; a planarization layer 6 bonded to only a surface of the composite substrate 11; and a single-crystal silicon layer 7 bonded to the planarization layer 6.

Using such a substrate 10 for GaN film formation, a GaN epitaxial substrate (a nitride semiconductor substrate) with a large diameter, a large thickness of epitaxial layer (nitride semiconductor thin film), and a crack-free can be produced. Moreover, such a substrate 10 for GaN film formation has an extremely small difference in the coefficient of thermal expansion with GaN, thus, a warp generation is less likely during a growing and a cooling of GaN. Consequently, not only the warp of a substrate after a film-forming is controllable to a small degree, but also a time for the epitaxial growth can be shortened because a complicated stress relaxation layer provided in the epitaxial layer is unnecessary, resulting in significant cost reductions for the epitaxial growth. Furthermore, the substrate for GaN film formation is mostly ceramics thus, not only is the substrate very hard and less likely to develop plastic deformation, but also the substrate does not generate wafer cracks that are unsolved in GaN/Si having a large diameter.

In the GaN epitaxial wafer, it is known that forming a thick GaN film widens an insulating region, resulting in a higher breakdown voltage and an improved high-frequency characteristics. The substrate for GaN film formation can form the thick GaN film, thus is very advantageous for improving these characteristics.

Patent Document 1 discloses a technique of a bonded substrate (a composite substrate for growing GaN) with a coefficient of thermal expansion close to GaN. However, a technique to reduce a high-frequency-signal loss by such an impurity doping is not disclosed.

Patent Document 2 discloses a nitride semiconductor substrate including a buffer layer containing a GaN layer having a carbon concentration of 7×10¹⁹/cm³, however, a bonded substrate having a substrate for film formation including a composite substrate with a plurality of layers bonded together is not disclosed. Moreover, in Patent Document 2, a carbon-doped GaN layer is as thin as about 1000 nm, and such as Fe-doping is not referred to.

Patent Document 3 discloses a technique to reduce a leakage current in the lateral direction by doping carbon (C) or iron (Fe), however, this does not provide a bonded substrate, and an improvement of high-frequency characteristics and resistivity of the substrate is not referred to.

No document has disclosed a technique for improving high-frequency characteristics at a film formation for a nitride semiconductor thin film on a substrate for GaN film formation.

### CITATION LIST

### PATENT LITERATURE

Patent Document 1: JP 2019-523994 A
Patent Document 2: JP 2013-80776 A
Patent Document 3: WO 2017/002317 A1

### SUMMARY OF INVENTION

### TECHNICAL PROBLEM

As described above, when GaN film is formed on a substrate for GaN film formation, the film formation of a thick GaN layer is possible. Moreover, because a complicated buffer structure is unnecessary, the film can be formed in a structure that is less prone to generate two-dimensional electron gas (2DEG). Thus, high-frequency characteristics are improved.

Meanwhile, as described above, to meet both an acceleration of communication speed, such as 5G, and even further acceleration of communication speed in the future, further improvement of the high-frequency characteristics is necessitated. As a result, present characteristics might be unable to meet these requirements.

Regarding the film formation of GaN on the substrate for GaN film formation, a doping amount of C or Fe is small (or not being doped) unless a growth condition is devised, thus, a drastic change in the high-frequency characteristics does not occur. Moreover, since a Si layer of the typical substrate for GaN film formation has low resistance, there is a problem that high-frequency characteristics are degraded due to the Si layer serving as a leakage path.

The present invention has been made in view of the above-described problem. An object of the present invention is to provide a nitride semiconductor substrate with improved high-frequency characteristics and a method of producing the nitride semiconductor substrate.

### SOLUTION TO PROBLEM

To achieve the above object, the present invention provides a nitride semiconductor substrate comprising:
a substrate for film formation including a composite substrate with a plurality of layers bonded together and a single-crystal silicon layer formed on the composite substrate; and
a nitride semiconductor thin film formed on the substrate for film formation, wherein
the nitride semiconductor thin film includes a GaN layer, and
the GaN layer is doped with at least 1×10¹⁹ atoms/cm³ or more and less than 5×10²⁰ atoms/cm³ of carbon and/or 5×10¹⁸ atoms/cm³ or more and less than 5×10²⁰ atoms/cm³ of iron.

The GaN layer in the nitride semiconductor thin film formed on the substrate for film formation is doped with carbon or iron or both in the above concentrations, which forms deep levels in the GaN layer and makes the GaN highly resistive (semi-insulated). Thus, transmitting high-frequency signals in the GaN layer is made difficult, and high-frequency loss in the nitride semiconductor substrate (the bonded substrate) is reduced. As a result, high-frequency characteristics can be improved.

On the other hand, in the case of a carbon concentration of 5×10²⁰ atoms/cm³ or more, an exceeding amount of doping may prevent obtaining characteristics as GaN. In the case of an iron concentration of 5×10²⁰ atoms/cm³ or more, alloying occurs, and characteristics as GaN may not be obtained.

The GaN layer preferably has at least 3 um or more of a portion doped with both carbon and iron.

With such a nitride semiconductor substrate, high-frequency loss can be further reduced.

A thickness of the GaN layer is preferably 6 um or more and 20um or less.

With such a nitride semiconductor substrate, transmitting high-frequency signals in the GaN layer is made more difficult, and high-frequency loss in the nitride semiconductor substrate (the bonded substrate) can be reduced.

The nitride semiconductor thin film preferably further comprises any one selected from the group consisting of a GaN layer which is different from the GaN layer, an AlN layer, and an AlGaN layer.

With such a nitride semiconductor substrate including a nitride semiconductor thin film containing these materials, high-frequency characteristics can be certainly improved.

The single-crystal silicon layer of the substrate for film formation preferably has a resistivity of 3000 Ω▪cm or more and 10000 Ω▪cm or less.

If the single-crystal silicon layer of the substrate for film formation has such a high resistivity, the high-frequency characteristics are not degraded due to a leakage path caused by the single-crystal silicon layer.

In addition, the substrate for film formation preferably comprises:
the composite substrate including a polycrystalline ceramic core, a first adhesive layer bonded entirely to the polycrystalline ceramic core, a conductive layer bonded entirely to the first adhesive layer as needed; a second adhesive layer bonded entirely to the conductive layer or entirely to the first adhesive layer, and a barrier layer bonded entirely to the second adhesive layer;
a planarization layer bonded to only one side of the composite substrate; and
the single-crystal silicon layer bonded to the planarization layer.

With the nitride semiconductor substrate using such a substrate for film formation, a warp of a substrate after a film formation can be controlled to a small degree.

Alternatively, the substrate for film formation preferably comprises:
a composite substrate including a polycrystalline ceramic core, a first adhesive layer bonded entirely to the polycrystalline ceramic core, a barrier layer bonded entirely to the first adhesive layer, a second adhesive layer bonded to a back surface of the barrier layer, a conductive layer bonded to the back surface of the second adhesive layer;
a planarization layer bonded to only a front surface of the composite substrate; and
a single-crystal silicon layer bonded to the planarization layer.

With the nitride semiconductor substrate using such a substrate for film formation, a leakage path due to the conductive layer on the front surface of the substrate for film formation is not generated, and excellent high-frequency characteristics can be achieved.

Alternatively, the substrate for film formation preferably comprises:
a composite substrate including a polycrystalline ceramic core, a first adhesive layer bonded entirely to the polycrystalline ceramic core, a conductive layer bonded to a back surface of the first adhesive layer, a second adhesive layer bonded to a back surface of the conductive layer, a barrier layer bonded to a front surface and a side surface of the first adhesive layer, to a side surface of the conductive layer, and to a side surface and a back surface of the second adhesive layer,
a planarization layer bonded to only a front surface of the composite substrate; and
a single-crystal silicon layer bonded to the planarization layer.

Also with a nitride semiconductor substrate using such a substrate for film formation, a leakage path due to the conductive layer on the front surface of the substrate for film formation is not generated, and excellent high-frequency characteristics can be achieved.

In this case, the polycrystalline ceramic core preferably contains aluminum nitride.

With the nitride semiconductor substrate using such a substrate for film formation, warp of a substrate after a film formation can be controlled to a much smaller degree and a thick nitride semiconductor thin film can be formed.

Furthermore, the present invention provides a method of producing a nitride semiconductor substrate comprising the steps of:
providing at least a composite substrate with a plurality of layers bonded together and a single-crystal silicon substrate;
bonding the composite substrate to the single-crystal silicon substrate via a planarization layer;
thinning the single-crystal silicon substrate into a single-crystal silicon layer;
growing an AlN layer on the single-crystal silicon layer; and
growing a GaN layer on the AlN layer, wherein
the GaN layer is grown with doping with at least 1×10¹⁹ atoms/cm³ or more and less than 5×10²⁰ atoms/cm³ of carbon and/or 5×10¹⁸ atoms/cm³ or more and less than 5×10²⁰ atoms/cm³ of iron in the step of growing GaN layer.

Such a method of producing a nitride semiconductor substrate can relatively easily and reliably produce the nitride semiconductor substrate with excellent high-frequency characteristics.

Additionally, the composite substrate with the plurality of layers bonded together is preferably provided in which the composite substrate includes a polycrystalline ceramic core, a first adhesive layer bonded entirely to the polycrystalline ceramic core, a conductive layer bonded entirely to the first adhesive layer as needed, a second adhesive layer bonded entirely to the conductive layer or entirely to the first adhesive layer, and a barrier layer bonded entirely to the second adhesive layer.

Such a method of producing a nitride semiconductor substrate can easily produce the nitride semiconductor substrate in which the warp of a substrate after a film formation is controlled to a small degree.

Alternatively, the composite substrate with the plurality of layers bonded together is preferably provided in which the composite substrate includes a polycrystalline ceramic core, a first adhesive layer bonded entirely to the polycrystalline ceramic core, a barrier layer bonded entirely to the first adhesive layer, a second adhesive layer bonded to a back surface of the barrier layer, and a conductive layer bonded to the back surface or the second adhesive layer.

Such a method of producing a nitride semiconductor substrate can produce the nitride semiconductor substrate in which a leakage path due to the conductive layer on the front surface of the composite substrate is not generated, and excellent high-frequency characteristics can be achieved.

Alternatively, the composite substrate with the plurality of layers bonded together is preferably provided in which the composite substrate includes a polycrystalline ceramic core, a first adhesive layer bonded entirely to the polycrystalline ceramic core, a conductive layer bonded to the back surface of the first adhesive layer, a second adhesive layer bonded to a back surface of the conductive layer, a barrier layer bonded to a front surface and a side surface of the first adhesive layer, to a side surface of the conductive layer, and to a side surface and a back surface of the second adhesive layer.

Such a method of producing a nitride semiconductor substrate can also produce the nitride semiconductor substrate in which a leakage path due to the conductive layer on the front surface of the composite substrate is not generated, and excellent high-frequency characteristics can be achieved.

### ADVANTAGEOUS EFFECTS OF INVENTION

As described above, the inventive nitride semiconductor substrate can exhibit improved high-frequency characteristics. Thus, the inventive nitride semiconductor substrate can meet an acceleration of a communication speed, for example.

In addition, the inventive method of producing a nitride semiconductor substrate can relatively easily and reliably produce the nitride semiconductor substrate with excellent high-frequency characteristics.

### BRIEF DESCRIPTION OF DRAWINGS

FIG. 1 is a view illustrating a schematic cross-sectional view of an example of a nitride semiconductor substrate according to the present invention.
FIG. 2 is a schematic constitutional view illustrating samples produced in Examples and Comparative Example.
FIG. 3 is a schematic plane view illustrating a coplanar waveguide used for studying harmonic characteristics of samples produced in Examples and Comparative Example.
FIG. 4 is a view illustrating a schematic cross-sectional view of the coplanar waveguide shown in FIG. 3.
FIG. 5 is a graph illustrating the harmonic characteristics of samples produced in Examples and Comparative Example.
FIG. 6 is a graph illustrating a relation between a carbon concentration and harmonic characteristics.
FIG. 7 is a view illustrating an example of a schematic cross-sectional view of a substrate for film formation.
FIG. 8 is a view illustrating another example of a schematic cross-sectional view of a substrate for film formation.
FIG. 9 is a view illustrating still another example of a schematic cross-sectional view of a substrate for film formation.

### DESCRIPTION OF EMBODIMENTS

As described above, a further improvement of high-frequency characteristics of a GaN HEMT has been desired.

To solve the above problem, the present inventors have earnestly studied to improve the high-frequency characteristics of the GaN HEMT and found out that by virtue of a nitride semiconductor substrate including a substrate for film formation including a composite substrate and a single-crystal silicon layer formed on the composite substrate; and a nitride semiconductor thin film formed on the substrate for film formation; in which a GaN layer in the nitride semiconductor thin film is doped with carbon or iron or both within a concentration of a predetermined range, high-frequency characteristics can be improved. This finding has led to the completion of the present invention.

That is, the present invention is a nitride semiconductor substrate comprising:
a substrate for film formation including a composite substrate with a plurality of layers bonded together and a single-crystal silicon layer formed on the composite substrate; and
a nitride semiconductor thin film formed on the substrate for film formation, wherein
the nitride semiconductor thin film includes a GaN layer, and
the GaN layer is doped with at least 1×10¹⁹ atoms/cm³ or more and less than 5×10²⁰ atoms/cm³ of carbon and/or 5×10¹⁸ atoms/cm³ or more and less than 5×10²⁰ atoms/cm³ of iron.

Moreover, the present invention is a method of producing a nitride semiconductor substrate comprising the steps of:
providing at least a composite substrate with a plurality of layers bonded together and a single-crystal silicon substrate;
bonding the composite substrate to the single-crystal silicon substrate via a planarization layer;
thinning the single-crystal silicon substrate into a single-crystal silicon layer;
growing an AlN layer on the single-crystal silicon layer; and
growing a GaN layer on the AlN layer, wherein
the GaN layer is grown with doping with at least 1×10¹⁹ atoms/cm³ or more and less than 5×10²⁰ atoms/cm³ of carbon and/or 5×10¹⁸ atoms/cm³ or more and less than 5×10²⁰ atoms/cm³ of iron in the step of growing GaN layer.

Hereinafter, the present invention will be described in detail with reference to the drawings. However, the present invention is not limited thereto.

### [Nitride semiconductor substrate]

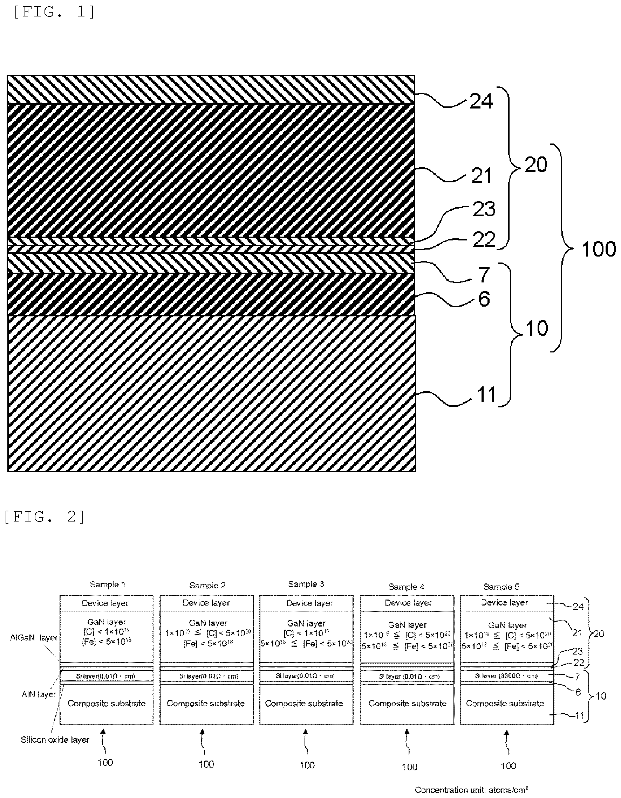

To begin with, one example of the inventive nitride semiconductor substrate is described by referring to FIG. 1.

A nitride semiconductor substrate 100 shown in FIG. 1 includes a substrate 10 for film formation and a nitride semiconductor thin film 20 film-formed on the substrate 10 for film formation.

The nitride semiconductor thin film 20 includes a GaN layer 21. The GaN layer 21 is doped with at least 1×10¹⁹ atoms/cm³ or more and less than 5×10²⁰ atoms/cm³ of carbon and/or 5×10¹⁸ atoms/cm³ or more and less than 5×10²⁰ atoms/cm³ of iron.

In such nitride semiconductor substrate 100, deep levels are formed in the GaN layer 21, and the GaN is made highly resistive (semi-insulated). Thus, transmitting a high-frequency signal in the GaN layer 21 becomes more difficult, and high-frequency loss in the nitride semiconductor substrate 100 (the bonded substrate) is reduced. As a result, high-frequency characteristics can be improved.

On the other hand, if the GaN layer 21 has a carbon concentration of 5×10²⁰ atoms/cm³ or more, an exceeding amount of doping may prevent obtaining characteristics as GaN. If an iron concentration is 5×10²⁰ atoms/cm³ or more, alloying occurs, and characteristics as GaN may not be obtained. Moreover, if the carbon concentration in the GaN layer 21 is less than 1×10¹⁹ atoms/cm³ and the iron concentration in the layer is less than 5×10¹⁸ atoms/cm³, an improvement of harmonics characteristics is unachievable.

The GaN layer 21 is further preferably doped with 1.0×10¹⁹ atoms/cm³ or more and less than 1.0×10²⁰ atoms/cm³ of carbon and/or doped with 1.0×10¹⁹ atoms/cm³ or more and less than 1.0×10²⁰ atoms/cm³ of iron.

An amount of doping with carbon (the carbon concentration) and an amount of doping with iron (the iron concentration) in the GaN layer 21 can be measured by such as Secondary Ion Mass Spectrometry (SIMS).

The GaN layer 21 preferably has at least 3 um or more of a portion doped with both carbon and iron.

With such a nitride semiconductor substrate 100, high-frequency loss can be further reduced.

An upper limit of a thickness of the GaN layer 21 doped with both carbon and iron is not particularly limited but can be 6 um or less.

The thickness of the GaN layer 21 is preferably 6 um or more and 20 um or less.

With such a nitride semiconductor substrate 100, transmitting high-frequency signals in the GaN layer 21 can be made more difficult, and then high-frequency loss in the nitride semiconductor substrate 100 (the bonded substrate) can be reduced.

The nitride semiconductor thin film 20 can include a different layer from the GaN layer 21.

The nitride semiconductor thin film 20 preferably includes any one selected from the group consisting of a GaN layer which is different from the GaN layer, an AlN layer, and an AlGaN layer.

With the nitride semiconductor substrate including a nitride semiconductor thin film containing these materials, high-frequency characteristics can be certainly improved.

For example, the nitride semiconductor thin film 20, shown in FIG. 1, further includes an AlN layer 22, an AlGaN layer 23, and a device layer 24. The AlN layer 22 is formed on a single-crystal silicon layer 7 of the substrate 10 for film formation. The AlGaN layer 23 is formed between the AlN layer 22 and the GaN layer 21. The device layer 24 is formed on the GaN layer 21 and includes a GaN layer, which is different from the GaN layer 21, and an AlGaN layer. However, the nitride semiconductor thin film 20 of the inventive nitride semiconductor substrate 100 is not limited to the example shown in FIG. 1. For example, the AlGaN layer 23 can be omitted.

The nitride semiconductor thin film 20 may collectively have a thickness of 3 um or more and 30 um or less, for example.

Other details of a specific example of the nitride semiconductor thin film 20 will be described in the description of a method of producing a nitride semiconductor thin film of the present invention.

The substrate 10 for film formation of the nitride semiconductor substrate 100 includes a composite substrate 11 with a plurality of layers bonded together and a single-crystal silicon layer 7 formed on this composite substrate 11.

As shown in FIG. 1, the substrate 10 for film formation can further include a planarization layer 6 via which the composite substrate 11 and the single crystal silicon layer 7 are bonded to each other.

The substrate 10 for film formation shown in FIG. 1 has a similar configuration to a substrate 10 for GaN film formation described earlier referring to FIG. 7. In other words, as shown in FIG. 7, the substrate 10 for film formation includes: the composite substrate 11 including a polycrystalline ceramic core 1, a first adhesive layer 2 bonded entirely to the polycrystalline ceramic core 1, a conductive layer 3 bonded entirely to the first adhesive layer 2, a second adhesive layer 4 bonded entirely to the conductive layer 3, and a barrier layer 5 (a silicon nitride layer, for example) bonded entirely to the second adhesive layer 4; a planarization layer 6 bonded to only a surface of the composite substrate 11; and a single-crystal silicon layer 7 bonded to the planarization layer 6.

With the nitride semiconductor substrate 100 using such a substrate 10 for film formation, a warp of the substrate after the film formation can be controlled to a small degree.

The polycrystalline ceramic core 1 preferably contains aluminum nitride.

With the nitride semiconductor substrate 100 using such a substrate 10 for film formation, the warp of the substrate after the film formation can be controlled to a much smaller degree and a formation of a thick nitride semiconductor thin film 20 is possible.

The composite substrate 11 included in the substrate 10 for film formation of the inventive nitride semiconductor substrate 100 is not limited to an example shown in FIG. 7. For example, the conductive layer 3 is bonded to the first adhesive layer 2 as needed, and is not essential. When the composite substrate 11 does not include the conductive layer 3, the second adhesive layer 4 can be bonded entirely to the first adhesive layer 2. A Specific example of the substrate 10 for film formation other than shown in the example illustrated in FIG. 7 will be described later.

The single-crystal silicon layer 7 of the substrate 10 for film formation preferably has a resistivity of 3000 Ω▪cm or more and 10000 Ω▪cm or less.

If the single-crystal silicon layer 7 of the substrate 10 for film formation has such a high resistivity, high-frequency characteristics are not degraded due to a leakage path caused by the single-crystal silicon layer 7.

Other details of a specific example of the substrate 10 for film formation will be described in the description of the method of producing the nitride semiconductor thin film of the present invention.

### [Method of producing nitride semiconductor substrate]

Then, an example of the inventive method of producing a nitride semiconductor substrate is described by referring to FIG. 1 and FIG. 7 again. However, the inventive method of producing a nitride semiconductor substrate is not limited to the example described below.

In this example, a substrate 10 for film formation that has been described by referring to FIG. 7, i.e., the substrate 10 for film formation including a composite substrate 11 bonded with a plurality of layers 1 to 5, a planarization layer 6 formed on the composite substrate 11, and a single-crystal silicon layer 7 formed on the planarization layer 6 is provided, then in an MOCVD apparatus, the epitaxial growth of a group III nitride semiconductor thin film 20 such as AlN, AlGaN and GaN is performed on the silicon layer 7 of the substrate 10 for film formation.

The substrate 10 for film formation shown in FIG. 7 is obtainable by the steps of: providing the composite substrate 11 with at least a plurality of layers 1 to 5 bonded together and a single-crystal silicon substrate, bonding the composite substrate 11 to a single-crystal silicon substrate via a planarization layer 6, and thinning the single-crystal silicon substrate into a single-crystal silicon layer 7.

In this case, the polycrystal ceramic core 1 of the composite substrate 11 includes aluminum nitride, for example, and it is sintered at a high temperature of such as 1800°C with a sintering additive and has such as a thickness of about 600 to 1150 um. Basically, the core is often formed to have a thickness of a Si substrate according to SEMI standards.

The first adhesive layer 2 and the second adhesive layer 4 are layers containing tetraethyl orthosilicate (TEOS) or silicon oxide (SiO₂), or both, and are deposited by such as a Low-Pressure Chemical Vapor Deposition (LPCVD) process or a CVD process, and have a thickness of about 50 to 200 nm, for example.

Then conductive layer 3 contains polysilicon, for example, and is deposited by such as the LPCVD process, and thus has a thickness of about 150 to 500 nm. This is the layer for imparting conductivity and is doped with such as boron (B) and phosphorus (P). This conductive layer 3 containing polysilicon is provided as needed and can be absent.

The barrier layer 5 is such as a silicon nitride layer and is deposited by the LPCVD process and the like, having a thickness of 100 nm to 1500 nm, for example. This is the layer for preventing diffusion elements in the polycrystalline ceramic core 1, such as yttrium, yttrium oxide, oxygen, metal impurities, and other trace elements into the environment of a semiconductor processing chamber and outgassing thereof during a high-temperature epitaxial growth process.

The planarization layer 6 is deposited by such as the LPCVD process and a thickness is about 500 nm to 3000 nm, for example. This planarization layer 6 is deposited for the planarization of an upper surface. A commonly used ceramics material for a film such as SiO₂, Al₂O₃, Si₃N₄, or silicon oxynitride (SiₓO_{y}N_{z}: 0<x<1, 0<y<2, 0≤z≤0.6) is selected.

For example, the single-crystal silicon layer 7 has, for example, a thickness of about 100 to 500 nm. This is the layer used for a growth surface for epitaxial growth for the others, such as GaN. The single-crystal silicon layer 7 is formed by the following steps. Firstly, the single-crystal silicon substrate is bonded to the planarization layer 6 by such as layer-transferring process, resulting in the bonding of the composite substrate 11 to the single-crystal silicon substrate via the planarization layer 6. Next, the single-crystal silicon substrate can be processed into the single-crystal silicon layer 7 by thinning. The method of thinning the single-crystal silicon substrate is not particularly limited, but conventional methods such as grinding, polishing, etching, and hydrogen ion delamination are applicable.

Should be noted that, such as the thickness of each layer, the production method, and the material used are not limited to the values described above, and not all layers are necessarily present. The specific example of the substrate 10 for film formation other than the example shown in FIG. 7 is described in a later section.

By using such a substrate 10 for film formation (a supporting substrate for GaN), the nitride semiconductor substrate 100 (a GaN epitaxial substrate) having a large diameter and a large thickness of a nitride semiconductor thin film 20 (an epitaxial layer), and with a crack-free can be produced. Moreover, such a substrate 10 for film formation has an extremely small difference in the coefficient of thermal expansion with GaN, thus, a warp generation is less likely during a growing and a cooling of GaN. Consequently, not only is the warp of the substrate after the film-forming controllable to a small degree, but also a time for the epitaxial growth is shortened because a complicated stress relaxation layer provided in the nitride semiconductor thin film 20 that is the epitaxial layer is unnecessary, and, As a result, a cost of the epitaxial growth is significantly reduced. Furthermore, the substrate 10 for film formation is mostly ceramics, thus, the substrate itself is very hard and does not easily develop plastic deformation. Consequently, a wafer cracking, which is unsolved in GaN/Si having a large diameter, is not generated.

When the nitride semiconductor thin film 20 is formed, the substrate 10 for film formation is mounted on a wafer pocket called a satellite, and a nitride semiconductor is epitaxially grown on the single-crystal silicon layer 7. In respect of the nitride semiconductor thin film 20 (an epitaxial layer), an AlN layer 22 and an AlGaN layer 23 are sequentially film-formed from a side of the substrate 10 for film formation toward a growth direction, and then a GaN layer 21 is epitaxially grown (a step of growing the AlN layer 22 on the single-crystal silicon layer 7, and a step of growing the GaN layer 21 on the AlN layer 22). However, a structure of the nitride semiconductor thin film 20 that is the epitaxial layer is not limited to thereto and may include a case without film-forming the AlGaN layer 23, a case in which an AlN layer is further film-formed after the film formation of the AlGaN layer 23. Moreover, a plurality of the AlGaN layer 23 with an Al composition being changed may be film-formed.

A thickness of the AlN layer 22 can be, for example, 50 to 150 nm, a thickness of the AlGaN layer 23 can be such as 100 to 300 nm, and a thickness of the GaN layer 21 can be 6 to 20 µm, for instance. In epitaxial growth, TMAl as an Al source, TMGa as a Ga source, and NH₃ as an N source can be used. Moreover, a carrier gas can be N₂, H₂, or either of them, for example. A temperature of the process can be about 900 to 1200°C, for instance. The process for the epitaxial growth is not limited thereto, and other material and a film-forming temperature is applicable.

In addition, in the present invention, in the process of growing the GaN layer 21, the GaN layer 21 is grown while at least doping 1×10¹⁹ atoms/cm³ or more and less than 5×10²⁰ atoms/cm³ of carbon and/or doping 5×10¹⁸ atoms/cm³ or more and less than 5×10²⁰ atoms/cm³ of iron. Regarding the carbon source, carbon contained in TMGa can be also introduced by lowering the film-forming temperature. In addition, doping with carbon is also possible while introducing such as acetylene (C₂H₂). Moreover, ferrocene (Fe(C₅H₅)₂ / bis(cyclopentadienyl)iron(II) complex) can also be used as an iron source. By thus doping with carbon and iron, deep levels are formed in the GaN layer 21, and the GaN is made highly resistive (semi-insulated). Thus, transmitting high-frequency signals in the GaN layer 21 becomes difficult, as a result, high-frequency characteristics can be improved. The GaN layer is preferably grown to have at least 3 um of a portion doped with both (simultaneously) carbon and iron.

A device layer 24 can be provided at the upper position (toward a growth direction) above the GaN layer 21. The device layer 24 can have a structure including a highly-crystalized layer (channel layer) generating two-dimensional electron gas with a thickness of about 400 nm, a layer to generate two-dimensional electron gas (barrier layer) with a thickness of about 20 nm, and a Cap layer at the uppermost surface layer with a thickness of 3 nm more or less.

Regarding the barrier layer in the device layer 24, AlGaN with an Al composition of 20 % can be used, for example. Additionally, such as InGaN can also be used. Moreover, the Cap layer can be, for example, the GaN layer, but can also be, for example, a SiN layer. Furthermore, the above-described thickness of each layer in the device layer 24 or the Al composition of the barrier layer are changeable depending on a device design and thus are not limited to thereof. The thickness of the GaN layer 21 in the nitride semiconductor thin film 20 is preferably 6 um or more and 20 um or less.

The inventive nitride semiconductor substrate described above can be produced, for example, by the inventive method of producing the nitride semiconductor substrate described here. However, the inventive semiconductor substrate may be produced by another producing method.

Hereinafter, specific examples of the substrate 10 for film formation other than the example shown in FIG. 7 are described.

Another example of the substrate for film formation may be, for example, a substrate 10 for film formation that, as shown in FIG. 8, includes a composite substrate 11 including a polycrystalline ceramic core 1, a first adhesive layer 2 bonded entirely to the polycrystalline ceramic core 1, a barrier layer 5 bonded entirely to the first adhesive layer 2, a second adhesive layer 4 bonded to a back surface of the barrier layer 5, a conductive layer 3 bonded to the back surface of the second adhesive layer 4; a planarization layer 6 bonded to only a front surface of the composite substrate 11; and a single-crystal silicon layer 7 bonded to the planarization layer 6.

With the nitride semiconductor substrate using the substrate 10 for film formation having such a structure in which the conductive layer 3 is formed only on the back surface, a leak path due to the conductive layer on the front surface of the substrate 10 for film formation is not generated when a high-frequency device is produced, resulting in excellent high-frequency characteristics.

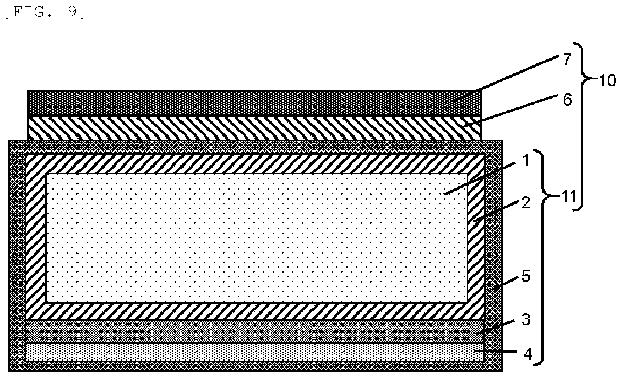

Moreover, still another example of a substrate for film formation is, for example, the substrate 10 for film formation that, as shown in FIG. 9, includes a composite substrate 11 including a polycrystalline ceramic core 1, a first adhesive layer 2 bonded entirely to the polycrystalline ceramic core 1, a conductive layer 3 bonded to a back surface of the first adhesive layer 2, a second adhesive layer 4 bonded to a back surface of the conductive layer 3, a barrier layer 5 bonded to a front surface and a side surface of the first adhesive layer 2, to a side surface of the conductive layer 3, and to a side surface and a back surface of the second adhesive layer 4; a planarization layer 6 bonded to only a front surface of the composite substrate 11; and a single-crystal silicon layer 7 bonded to the planarization layer 6.

With the nitride semiconductor substrate using the substrate 10 for film formation having such a structure in which the conductive layer 3 is formed only on the back surface, a leak path due to the conductive layer on the front surface of the substrate 10 for film formation is also not generated when a high-frequency device is produced, resulting in excellent high-frequency characteristics.

The thickness of each layer of the substrate 10 for film formation shown in each of FIG. 8 and FIG. 9 is not particularly limited but can be, for example, the same as the thickness of each layer as described in FIG. 7.

### EXAMPLE

Hereinafter, the present invention will be specifically described with reference to Examples and Comparative Example. However, the present invention is not limited thereto.

In Comparative Example and Examples 1 to 4, each sample 1 to 5 of a nitride semiconductor substrate 100, having a configuration shown in FIG. 2, is produced by following procedures.

A growth substrate 10 having a configuration shown in FIG. 7 with a diameter of 150 mm was mounted on a satellite in a MOCVD apparatus. Specifically, the growth substrate 10 had the configuration of a composite substrate 11 including a polycrystalline ceramic core 1, a first adhesive layer (SiO₂) 2 bonded entirely to the polycrystalline ceramic core 1, a conductive layer (poly-Si) 3 bonded entirely to the first adhesive layer 2, a second adhesive layer (SiO₂) 4 bonded entirely to the conductive layer 3, a barrier layer (Si₃N₄) 5 bonded entirely to the second adhesive layer 4; a silicon oxide layer 6 as a planarization layer bonded to only one surface of the composite substrate 11; and a single-crystal silicon layer 7 bonded to the silicon oxide layer 6.

In each Comparative Example and Examples 1 to 4, a single-crystal silicon layer 7 with resistance values described below and shown in FIG. 2 was used. In addition, the single-crystal silicon layer 7 was obtained by bonding the composite substrate 11 and the single-crystal silicon substrate via the silicon oxide layer 6 and then thinning the single-crystal silicon substrate.

Then, an AlN layer 22 with a thickness of 100 nm was grown on the single-crystal silicon layer 7 of the growth substrate 10. After that, an AlGaN layer 23 of 150 nm was grown on the AlN layer 22.

Then, a GaN layer 21 with a thickness of 8 µm was epitaxially grown on the AlGaN 23. In Examples 1 to 4, the GaN layer 21 with a thickness of 8 µm was grown while doping carbon and/or iron to achieve a concentration described below. Acetylene gas was used as a carbon source. In addition, ferrocene was used as an iron source. In Comparative Example, the GaN layer 21 with a thickness of 8 µm was grown by epitaxial growth without doping either carbon or iron.

Furthermore, a device layer 24 was formed on the GaN layer 21, then a nitride semiconductor thin film 20 was obtained in which the AlN layer 22, the AlGaN layer 23, the GaN layer 21, and the device layer 24 were included.

Accordingly, five samples of the nitride semiconductor substrate 100 were produced here, as shown below and shown in FIG. 2, changing the resistivity of the single-crystal silicon layer 7 of the substrate 10 for film formation and changing concentrations of carbon and/or iron in the GaN layer 21.

Sample 1 (Comparative Example): a single-crystal silicon layer 7 of a substrate 10 for film formation had low resistance (0.01 Ω▪cm), carbon concentration was less than 1×10¹⁹ atoms/cm³ (7.5×10¹⁸ atoms/cm³), and iron concentration was less than 5×10¹⁸ atoms/cm³ (1.0×10¹⁸ atoms/cm³) in a GaN layer 21;

Sample 2 (Example 1): a single-crystal silicon layer 7 of a substrate 10 for film formation had low resistance (0.01 Ω▪cm), carbon concentration was 1×10¹⁹ atoms/cm³ or more and less than 5×10²⁰ atoms/cm³ (2.0×10¹⁹ atoms/cm³), and iron concentration was less than 5×10¹⁸ atoms/cm³ (1.0×10¹⁸ atoms/cm³) in a GaN layer 21;

Sample 3 (Example 2): a single-crystal silicon layer 7 of a substrate 10 for film formation had low resistance (0.01 Ω▪cm), carbon concentration was less than 1×10¹⁹ atoms/cm³ (7.5×10¹⁸ atoms/cm³), and iron concentration was 5×10¹⁸ atoms/cm³ or more and less than 5×10²⁰ atoms/cm³ (5.4×10¹⁸ atoms/cm³) in a GaN layer 21;

Sample 4 (Example 3): a single-crystal silicon layer 7 of a substrate 10 for film formation had low resistance (0.01 Ω▪cm), carbon concentration was 1×10¹⁹ atoms/cm³ or more and less than 5×10²⁰ atoms/cm³ (2.0×10¹⁹ atoms/cm³), and iron concentration was 5×10¹⁸ atoms/cm³ or more and less than 5×10²⁰ atoms/cm³ (5.4×10¹⁸ atoms/cm³) in a GaN layer 21;

Sample 5 (Example 4): a single-crystal silicon layer 7 of a substrate 10 for film formation had high resistance (3300 Ω▪cm), carbon concentration was 1×10¹⁹ atoms/cm³ or more and less than 5×10²⁰ atoms/cm³ (2.0×10¹⁹ atoms/cm³), and iron concentration was 5×10¹⁸ atoms/cm³ or more and less than 5×10²⁰ atoms/cm³ (5.4×10¹⁸ atoms/cm³) in a GaN layer 21.

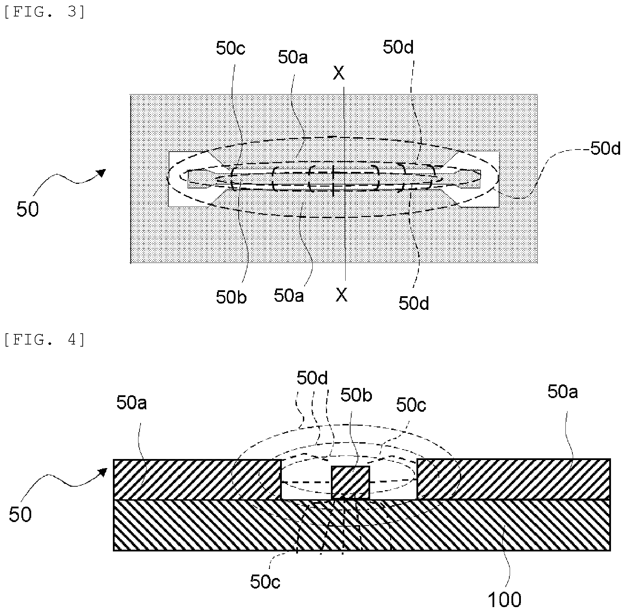

After the epitaxial growth, a metal electrode (a coplanar waveguide) was formed on the surface of the nitride semiconductor thin film 20, and then high-frequency characteristics were evaluated. A shape of the electrode is shown in FIG. 3 and 4.

In more detail, the formed coplanar waveguide 50 had a structure in which metal electrodes 50a were arranged in a row with a gap therebetween, and a center of the gap had a central metal electrode 50b having a linear shape in parallel with these metal electrodes 50a. The structure was designed to transmit an electromagnetic wave by an electric field 50c in the direction from the central metal electrode 50b to the metal electrodes 50a on both the left and right sides in FIG. 4 and to the interior of the nitride semiconductor substrate 100, and a magnetic field 50d in the direction surrounding the central metal electrode 50b inside the nitride semiconductor substrate 100.

Then, high-frequency characteristics were evaluated for each sample of the nitride semiconductor substrate 100. As for the evaluation method for high-frequency characteristics, the method includes: making probe contacts with the coplanar waveguide 50, inputting a signal of 1GHz from one side with changing signal strength, and measuring an output intensity of second harmonic waves outputted from an opposite side of the coplanar waveguide 50.

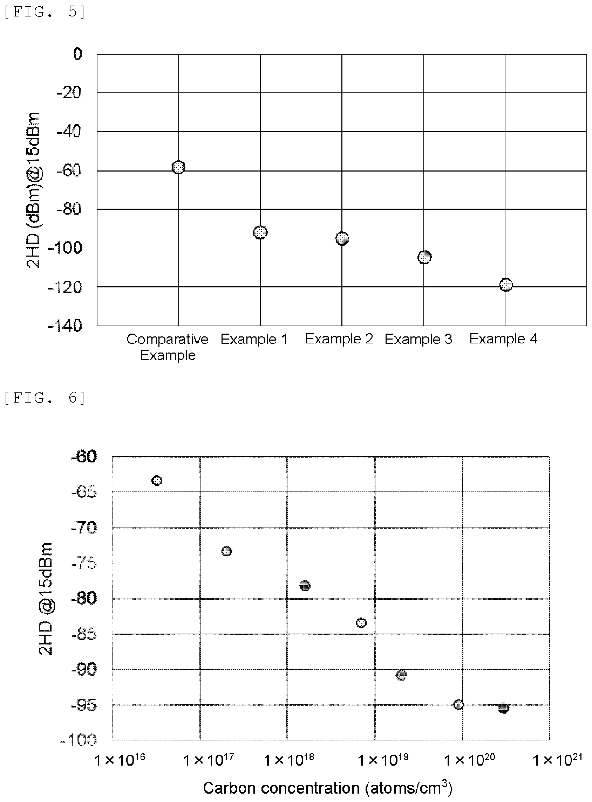

Then, to evaluate the difference among the samples, the output intensities of the second harmonic wave were compared at a high-frequency input signal strength of Pin = 15 dBm. A result is shown in FIG. 5.

As is obvious from FIG. 5, samples 2 to 5 (Examples 1 to 4) have second harmonic waves with low intensity compared with sample 1 (Comparative Example). Thus, it was proved that the high-frequency signal leaked to the substrate side was smaller, and the signal transmitting within the electrode was greater in samples 2 to 5.

Then, an experiment with changing carbon concentration in a GaN layer was conducted with a single-crystal silicon layer of a substrate for film formation that had low resistance (0.01 Ω▪cm) with a constant Fe concentration of 1×10¹⁸ atoms/cm³ in a GaN layer. A result is shown in FIG. 6. It was found that the high-frequency characteristics improved as the carbon concentration increased. Moreover, when the carbon concentration was 1×10¹⁹ atoms/cm³ or more, the output intensity of the second harmonic was Pout=-90 dBm or less. As a result, an extremely excellent high-frequency characteristic was obtained.

Furthermore, although sample 4 (Example 3) had a lower carbon concentration than two samples shown on the right side in a graph of FIG. 6, sample 4 proved more excellent high-frequency characteristics than two samples having higher carbon concentration. This is considered that sample 4 was not only doped with carbon of 1×10¹⁹ atoms/cm³ or more and less than 5×10²⁰ atoms/cm³ but also doped with iron of 5×10¹⁸ atoms/cm³ or more and less than 5×10²⁰ atoms/cm³.

Furthermore, although sample 4 (Example 3) had the same iron concentration in the GaN layer as sample 3 (Example 2), it was found that sample 4 had more excellent high-frequency characteristics than sample 3, as shown in FIG. 5. This is considered that sample 4 was not only doped with the iron of 5×10¹⁸ atoms/cm³ or more and less than 5×10²⁰ atoms/cm³ but also doped with the carbon of 1×10¹⁹ atoms/cm³ or more and less than 5×10²⁰ atoms/cm³.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A nitride semiconductor substrate comprising:
a substrate for film formation including a composite substrate with a plurality of layers bonded together and a single-crystal silicon layer formed on the composite substrate; and
a nitride semiconductor thin film formed on the substrate for film formation, wherein
the nitride semiconductor thin film includes a GaN layer, and
the GaN layer is doped with at least 1×10¹⁹ atoms/cm³ or more and less than 5×10²⁰ atoms/cm³ of carbon and/or 5×10¹⁸ atoms/cm³ or more and less than 5×10²⁰ atoms/cm³ of iron.

2. The nitride semiconductor substrate, according to claim 1, wherein
the GaN layer has at least 3 um or more of a portion doped with both carbon and iron.

3. The nitride semiconductor substrate according to claim 1 or 2, wherein
a thickness of the GaN layer is 6 um or more and 20um or less.

4. The nitride semiconductor substrate according to any one of claims 1 to 3, wherein
the nitride semiconductor thin film further comprises any one selected from the group consisting of a GaN layer which is different from the GaN layer, an AlN layer, and an AlGaN layer.

5. The nitride semiconductor substrate according to any one of claims 1 to 4, wherein
the single-crystal silicon layer of the substrate for film formation has a resistivity of 3000 Ω▪cm or more and 10000 Ω▪cm or less.

6. The nitride semiconductor substrate according to any one of claims 1 to 5, wherein
the substrate for film formation comprises:
the composite substrate including a polycrystalline ceramic core, a first adhesive layer bonded entirely to the polycrystalline ceramic core, a conductive layer bonded entirely to the first adhesive layer as needed, a second adhesive layer bonded entirely to the conductive layer or entirely to the first adhesive layer, and a barrier layer bonded entirely to the second adhesive layer;
a planarization layer bonded to only one side of the composite substrate; and
the single-crystal silicon layer bonded to the planarization layer.

7. The nitride semiconductor substrate according to any one of claims 1 to 5, wherein
the substrate for film formation comprises:
a composite substrate including a polycrystalline ceramic core, a first adhesive layer bonded entirely to the polycrystalline ceramic core, a barrier layer bonded entirely to the first adhesive layer, a second adhesive layer bonded to a back surface of the barrier layer, a conductive layer bonded to the back surface of the second adhesive layer;
a planarization layer bonded to only a front surface of the composite substrate; and
a single-crystal silicon layer bonded to the planarization layer.

8. The nitride semiconductor substrate according to any one of claims 1 to 5, wherein
the substrate for film formation comprises:
a composite substrate including a polycrystalline ceramic core, a first adhesive layer bonded entirely to the polycrystalline ceramic core, a conductive layer bonded to a back surface of the first adhesive layer, a second adhesive layer bonded to a back surface of the conductive layer, a barrier layer bonded to a front surface and a side surface of the first adhesive layer, to a side surface of the conductive layer, and to a side surface and a back surface of the second adhesive layer;
a planarization layer bonded to only a front surface of the composite substrate; and
a single-crystal silicon layer bonded to the planarization layer.

9. The nitride semiconductor substrate according to claims any one of claims 6 to 8, wherein
the polycrystalline ceramic core contains aluminum nitride.

10. A method of producing a nitride semiconductor substrate comprising the steps of:
providing at least a composite substrate with a plurality of layers bonded together and a single-crystal silicon substrate;
bonding the composite substrate to the single-crystal silicon substrate via a planarization layer;
thinning the single-crystal silicon substrate into a single-crystal silicon layer;
growing an AlN layer on the single-crystal silicon layer; and
growing a GaN layer on the AlN layer, wherein
the GaN layer is grown with doping with at least 1×10¹⁹ atoms/cm³ or more and less than 5×10²⁰ atoms/cm³ of carbon and/or 5×10¹⁸ atoms/cm³ or more and less than 5×10²⁰ atoms/cm³ of iron in the step of growing GaN layer.

11. The method of producing a nitride semiconductor substrate according to claim 10, wherein
the composite substrate with the plurality of layers bonded together is provided in which the composite substrate comprises a polycrystalline ceramic core, a first adhesive layer bonded entirely to the polycrystalline ceramic core, a conductive layer bonded entirely to the first adhesive layer as needed, a second adhesive layer bonded entirely to the conductive layer or entirely to the first adhesive layer, and a barrier layer bonded entirely to the second adhesive layer.

12. The method of producing a nitride semiconductor substrate according to claim 10, wherein
the composite substrate with the plurality of layers bonded together is provided in which the composite substrate comprises a polycrystalline ceramic core, a first adhesive layer bonded entirely to the polycrystalline ceramic core, a barrier layer bonded entirely to the first adhesive layer, a second adhesive layer bonded to a back surface of the barrier layer, and a conductive layer bonded to the back surface or the second adhesive layer.

13. The method of producing a nitride semiconductor substrate according to claim 10, wherein
the composite substrate with the plurality of layers bonded together is provided in which the composite substrate comprises a polycrystalline ceramic core, a first adhesive layer bonded entirely to the polycrystalline ceramic core, a conductive layer bonded to the back surface of the first adhesive layer, a second adhesive layer bonded to a back surface of the conductive layer, a barrier layer bonded to a front surface and a side surface of the first adhesive layer, to a side surface of the conductive layer, and to a side surface and a back surface of the second adhesive layer.
